# Europäisches Patentamt

## European Patent Office
## Office européen des brevets

(19)

(11) Veröffentlichungsnummer: **0 014 304**
**B1**

(12) ## EUROPÄISCHE PATENTSCHRIFT

(45) Veröffentlichungstag der Patentschrift:
23.11.83

(51) Int. Cl.³: **G 01 R 31/28,** H 01 J 49/48, H 01 J 37/26

(21) Anmeldenummer: 80100016.7

(22) Anmeldetag: 03.01.80

(54) **Verfahren und Anordnung zur berührungslosen Potentialmessung an einem elektronischen Bauelement.**

(30) Priorität: 26.01.79 DE 2903077

(43) Veröffentlichungstag der Anmeldung:
20.08.80 Patentblatt 80/17

(45) Bekanntmachung des Hinweises auf die Patenterteilung:
23.11.83 Patentblatt 83/47

(84) Benannte Vertragsstaaten:
**GB NL**

(56) Entgegenhaltungen:
**IEEE JOURNAL OF SOLID-STATE CIRCUITS, Vol. SC-13, Nr. 3, Juni 1978, H.P. FEUERBAUM et al.: "Quantitative measurement with high time resolution of internal waveforms on MOS RAM's using a modified scanning electron microscope", Seiten 319-325**
**SOLID-STATE ELECTRONICS, Band 15, Nr. 9, September 1972, P.E. KUDIRKA et al.: "Potential measurement and stabilization of an isolated target using electron beams", Seiten 987-992**
**"Scanning electron microscopy" 1978 (Vol 1) SEM Inc. AMF o'Hare IL 60666 USA Seiten 795 bis 800**

(73) Patentinhaber: **SIEMENS AKTIENGESELLSCHAFT, Berlin und München Wittelsbacherplatz 2, D-8000 München 2 (DE)**

(72) Erfinder: **Feuerbaum, Hans-Peter, Dipl.Phys., Tucholskystrasse 22, D-8000 München 83 (DE)**

Verfahren und Anordnung zur berührungslosen Potentialmessung an einem elektronischen Bauelement

Die Erfindung bezieht sich auf ein Verfahren zur berührungslosen Potentialmessung an einem elektronischen Bauelement gemäss dem Oberbegriff des Anspruchs 1. Die Erfindung betrifft weiter eine Anordnung zur berührungslosen Potentialmessung an einem elektronischen Bauelement gemäss dem Oberbegriff des Anspruchs 3.

Das Potential in Leiterbahnen eines elektronischen Bauelements, insbesondere eines integrierten Schaltkreises, kann bekanntlich mit einem Elektronenmikroskop, insbesondere einem Rasterelektronenmikroskop, gemessen werden, dessen Primärelektronenstrahl an der Messstelle Sekundärelektronen auslöst, deren Energie vom Potential an der Messstelle bestimmt wird. Zur Energiemessung ist ein Gegenfeld-Spektrometer vorgesehen, das einen Ablenkkondensator enthält, welcher die Sekundärelektronen über ein Gegenfeld einem Elektronenkollektor zuführt, dem ein Fotomultiplier und ein Regelverstärker nachgeschaltet ist. Die Ausgangsspannung des Regelverstärkers steuert mit Hilfe einer Kompensationsschaltung (feedback loop) das Gegenfeld des Spektrometers und hält die Gitterspannung, bezogen auf die Spannung an der Messstelle des Bauelements, konstant. Die Gitterspannung an der Gegenfeldelektrode des Spektrometers wird solange nachgeregelt, bis die Spannung zwischen Gitter und Messpunkt wieder ihren ursprünglichen Wert erreicht hat. Dann entspricht die Änderung der Gitterspannung der Potentialänderung an der Messstelle des Bauelements, das als Probe dient ('Scanning Electron Microscopy', 1978, (Vol. I), SEM Inc. AMF O'Hare IL 60666, USA, Seiten 795–800).

In der bekannten Einrichtung wird durch Änderung der Fotomultiplierspannung ein günstiger Arbeitspunkt für den Regelkreis, der aus dem Spektrometer und dem Fotomultiplier sowie dem Vor- und Regelverstärker besteht, entsprechend der Signal-Potentialkennlinie des Regelkreises eingestellt. Obwohl in der angegebenen Veröffentlichung nicht ausdrücklich erwähnt, erfolgt bei der bekannten Einrichtung die Änderung der Fotomultiplierspannung von Hand. Anschliessend an die Einstellung des Arbeitspunkts wird bei der bekannten Einrichtung an das Bauelement die Betriebsspannung angelegt und, soweit erforderlich, von einer Ansteuerung (clock circuitry) die Steuertakte vorgegeben.

Verfahren und Anordnungen zur berührungslosen Potentialmessung an einem elektronischen Bauelement mit einem Elektronenmikroskop durch Messung der Energie der Sekundärelektronen mit einem Spektrometer, dem eine Kompensationsschaltung zugeordnet ist, sind ebenfalls aus folgenden beiden Veröffentlichungen bekannt: H.P. Feuerbaum et al, IEEE J. of Solid-State Circuits, Vol. SC-13, No. 3, Juni 1978, Seiten 319–325, und P.E. KUDIRKA et al, Solid-State Electronics, Bd. 15, No. 9, Sept. 1972, Seiten 987–992.

Der Erfindung liegt die Aufgabe zugrunde, ein Verfahren und eine Anordnung der eingangs genannten Art anzugeben, mit denen sowohl die Einstellung des Arbeitspunkts vor Durchführung einer Messung als auch die Messung selbst jeweils erleichtert werden.

Diese Aufgabe wird erfindungsgemäss durch ein Verfahren und eine Anordnung der eingangs genannten Art gelöst, welche die kennzeichnenden Merkmale des Anspruchs 1 bzw. des Anspruchs 3 aufweisen. Zur Einstellung des Arbeitspunkts kann der Messpunkt am Bauelement vorzugsweise auf Null-Potential gelegt werden. Zweckmässig werden damit gleich auch alle anderen Anschlüsse des Bauelements auf Null-Potential gelegt.

In einer besonders einfachen Ausführungsform einer Anordnung zur Durchführung des Verfahrens ist der Photomultipliersteuerung ein Komparator vorgeschaltet, dem das Ausgangssignal des Regelverstärkers und ein Sollwert vorgegeben sind. In Abhängigkeit vom Ausgangssignal des Komparators wird die Photomultiplierspannung so lange verstellt, bis das Ausgangssignal des Regelverstärkers gleich dem vorgegebenen Sollwert ist. Die Photomultipliersteuerung ist mit einer Einrichtung versehen, die dann die Photomultiplierspannung auf diesem Wert konstant hält. Der Komparator wird abgeschaltet, die Betriebsspannung an das Bauelement gelegt und dann der Sollwert mit dem Ausgangswert des Regelverstärkers einem Differenzverstärker vorgegeben, der dann als Ausgangssignal das Potential an der Messstelle liefert.

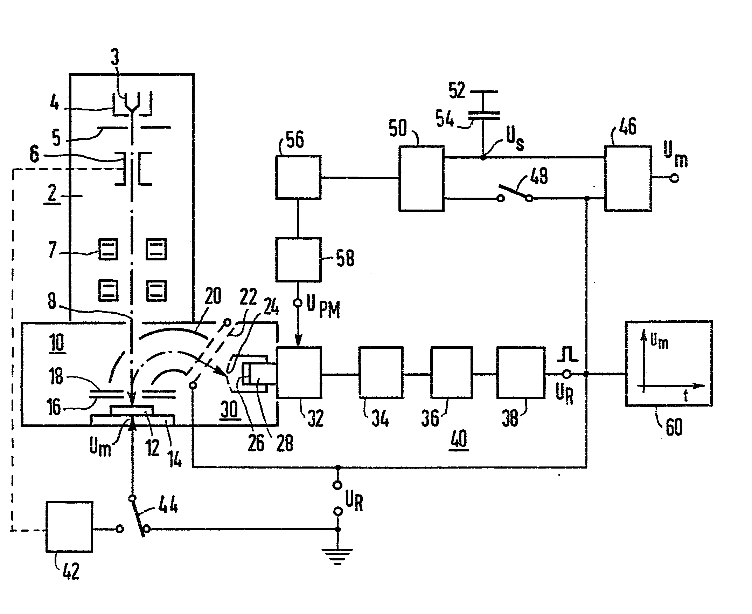

Zur weiteren Erläuterung der Erfindung wird auf die Zeichnung Bezug genommen, in der eine Ausführungsform einer Anordnung zur Durchführung des Verfahrens nach der Erfindung schematisch veranschaulicht ist.

In der Figur sind die elektronenoptische Säule eines Elektronenmikroskops, das vorzugsweise ein Rasterelektronenmikroskop sein kann, mit 2, eine Probenkammer mit 10, ein Spektrometer mit 30 und eine Kompensationsschaltung mit 40 bezeichnet. Die elektronenoptische Säule 2 enthält eine Elektronenkanone mit einer Kathode 3, einer Wehnelt-Elektrode 4 und einer Anode 5. Sie ist mit einem Strahltastsystem 6 sowie einem Ablenksystem 7 für den Primärelektronenstrahl 8 versehen, der durch eine nicht näher bezeichnete Blende in die Probenkammer 10 eintritt und an der Messstelle eines elektronischen Bauelements 12, das vorzugsweise ein integrierter Schaltkreis sein kann, das auf einem Sockel 14 befestigt ist, Sekundärelektronen auslöst, die durch das Feld einer Wehnelt-Elektrode 16 sowie einer Anode 18 abgesaugt und durch einen Kondensator 20 zum Elektronenkollektor abgelenkt werden. Die Sekundärelektronen gelangen auf ihrem strichpunktiert angedeuteten Weg über das Verzögerungsfeld zweier Gegenfeldelektroden 22 zum Elektronenkollektor des Spektrometers 30. Der Elektronenkollektor enthält zwischen seinem Abschirmgitter 24 und einem Szintillator 26 eine Beschleunigungsstrecke mit einer hohen Beschleunigungsspannung von beispielsweise 15 kV. Die im Szintillator 26 ausgelösten Photonen werden über einen Lichtleiter 28 einem Fotomultiplier 32 zugeführt, der im allgemeinen mit einem empfindlichen Vorverstärker 34 gekoppelt ist. Dem Vorverstärker 34 ist ein Komparator 36 nachgeschaltet, der das Ausgangssignal des Vorverstärkers mit einem vorgegebenen Soll-Wert vergleicht und in Abhängigkeit von der Differenz dieser Signale einen Regelverstärker 38 steuert. Das Ausgangssignal $U_R$ des Regelverstärkers 38 wird über eine nicht näher bezeichnete Rückkopplungsschleife der Gegenfeldelektrode 22 des Spektrometers 30 zugeführt, so dass das Spektrometer 30 mit dem Fotomultiplier 32 sowie dem Vorverstärker 34, dem Komparator 36 und dem Regelverstärker 38 eine Kompensationsschaltung 40 für das Spektrometer 30 bilden. Das Bauelement 12 erhält seine Steuertakte von einer Ansteuerung 42, die vorzugsweise mit der Tasteinrichtung 6 für den Primärelektronenstrahl 8 gekoppelt sein kann. Über einen Umschalter 44 kann die Messstelle des Bauelements 12 auf Null-Potential gelegt werden.

Das Reglerausgangssignal $U_R$ des Regelverstärkers 38 wird einem Differenzverstärker 46 und zugleich über einen Schalter 48 einem Komparator 50 zugeführt. Über eine Vorgabe 52 mit einem Kondensator 54 wird ein Soll-Wert $U_S$ jeweils dem zweiten Eingang des Differenzverstärkers 46 und des Komparators 50 vorgegeben. Der Ausgang des Komparators 50 ist mit dem Eingang einer Fotomultiplier-Steuerung 46 verbunden, die über ein Netzteil 58 die Fotomultiplierspannung $U_{PM}$ des Fotomultipliers 32 steuert. Das Reglerausgangssignal $U_R$ des Regelverstärkers 38 kann ausserdem einem Oszillografen 60 vorgegeben sein, auf dessen Bildschirm die Spannung $U_m$ an der Messstelle des Bauelements 12 in Abhängigkeit von der Zeit t aufgezeichnet werden kann.

Zur Potentialmessung wird zunächst der Arbeitspunkt des Spektrometers 30 eingestellt. Zu diesem Zweck wird mit dem Umschalter 44 die Messstelle des Bauelements 12 auf ein vorbestimmtes Potential gelegt, das vorzugsweise Null-Potential sein kann. Zweckmässig werden alle Anschlüsse des Bauelements 12 auf dieses Potential gelegt. Dann wird die Spannung an der Gegenfeldelektrode 22 des Spektrometers 30 durch Änderung der Fotomultiplierspannung $U_{PM}$ auf einen vorbestimmten Spannungswert eingestellt, der sich aus der Signal-Potentialkennlinie des Spektrometers ergibt. Das Ausgangssignal $U_R$ des Regelverstärkers 38 wird dem Komparator 50 zugeführt, dem auch der Soll-Wert $U_S$ vorgegeben ist. Das Ausgangssignal des Komparators 50 steuert über die Fotomultiplier-Steuerung 56 sowie das Netzteil 58 die Fotomultiplierspannung $U_{PM}$ solange, bis die Differenz der Eingangssignale des Komparators 50 Null und damit $U_{R1} = U_S$ ist. Damit ist der Arbeitspunkt des Spektrometers 30 eingestellt und der Gleichstromanteil am Messsignal $U_m$ kann gemessen werden. Mit dem Umschalter 44 werden von der Ansteuerung 42 dem Bauelement 12 die Steuertakte vorgegeben und ausserdem wird an das Bauelement 12 die Betriebsspannung, deren Quelle in der Figur nicht dargestellt ist, angelegt. Die Fotomultiplier-Steuerung 56 hält den eingestellten Wert der Fotomultiplierspannung $U_{PM}$ konstant. Sie kann zu diesem Zweck beispielsweise mit einem digitalen Speicher oder auch einem analogen Speicher versehen sein. Der Regelverstärker 38 liefert nunmehr ein Ausgangssignal $U_R = U_{R1} + U_m$, das um den Wert der Messspannung $U_m$ an der Messstelle des Bauelements erhöht ist. Der Differenzverstärker 46 erhält somit als Eingangssignal $U_R - U_S = U_{R1} + U_m - U_S$, und da der vorgegebene Soll-Wert $U_S$ gleich dem Reglerausgangssignal $U_{R1}$ im Arbeitspunkt des Spektrometers 30 ist, erhält man am Ausgang des Differenzverstärkers 46 die Messspannung $U_m$ aus $U_R - U_S = U_m$.

Die Messspannung $U_m$ kann auf dem Bildschirm eines Oszillografen 60 in Abhängigkeit von der Zeit t aufgezeichnet werden.

Mit der dargestellten Anordnung erhält man somit durch Vorgabe des Soll-Wertes $U_S$ zunächst in automatisierter Weise die erforderliche Einstellung des Arbeitspunkts des Spektrometers 30 und anschliessend den Ablauf der Arbeitsschritte zur Ermittlung der Messspannung $U_m$ an der Messstelle des Bauelements 12.

**Patentansprüche**

1. Verfahren zur berührungslosen Potentialmessung an einem elektronischen Bauelement, bei dem das Bauelement (12) in ein Elektronenmikroskop (2) eingebracht und ein Messpunkt mit Primärelektronen beaufschlagt wird, bei dem weiter der vom Messpunkt emittierte Sekundärelektronenstrom einem Gegenfeld-Spektrometer (20, 30) zugeführt wird, welches einen Fotomultiplier (32) aufweist sowie eine Kompensationsschaltung (40) mit einem Regelverstärker (38) zur Regelung des Gegenfeldes des Spektrometers (30) in Abhängigkeit von der Spannung ($U_m$) am Messpunkt (12), wobei der Regelverstärker mit dem Ausgang des Fotomultipliers (32) verbunden ist, bei dem ferner zunächst der optimale Arbeitspunkt der Kompensationsschaltung (40) vor Durchführung einer Messung dadurch eingestellt wird, dass der Messpunkt des Bauelements (12) auf ein vorbestimmtes Potential gelegt wird und dass dann die Ausgangsspannung ($U_{R1}$) des Regelverstärkers (38) über die Änderung der Fotomultiplierspannung ($U_{PM}$) eingestellt wird, während sich der Messpunkt des Bauelements (12) auf dem vorbestimmten Potential befindet, und dass sodann die Fotomultiplierspannung ($U_{PM}$) konstant gehalten wird, und bei dem anschliessend die Betriebsspannung an das Bauelement (12) angelegt wird, dadurch gekennzeichnet, dass zur Einstellung des optimalen Arbeitspunkts der Kompensationsschaltung (40) die Ausgangsspannung ($U_{R1}$) des Regelverstärkers (38), während sich der Messpunkt des Bauelements (12) auf dem vorbestimmten Potential befindet, mit einem vorbestimmten Soll-Wert ($U_S$) verglichen wird, dass die Fotomultiplierspannung ($U_{PM}$) in Abhängigkeit vom Ergebnis dieses Vergleichs gesteuert wird und dass sodann während der Messung des Potentials die Fotomultiplierspannung ($U_{PM}$) konstant gehalten wird.

2. Verfahren nach Anspruch 1, dadurch gekennzeichnet, dass der Messpunkt des Bauelements (12) auf Null-Potential als vorbestimmtes Potential gelegt wird.

3. Anordnung zur berührungslosen Potentialmessung an einem elektronischen Bauelement mit einem Elektronenmikroskop (2) zur Beaufschlagung eines Messpunkts auf dem Bauelement (12) mit Primärelektronen, einem die vom Messpunkt emittierten Sekundärelektronen erfassenden Gegenfeld-Spektrometer (20, 30), welches einen Fotomultiplier (32) mit angeschlossener Spannungsversorgung (58) sowie eine Kompensationsschaltung (40) zur Regelung des Gegenfeldes des Spektrometers (20, 30) in Abhängigkeit vom Potential am Messpunkt aufweist, wobei die Kompensationsschaltung (40) einen an den Ausgang des Fotomultipliers (32) angeschlossenen Regelverstärker (38) enthält, einer Betriebs- und einer Referenzspannungsquelle, sowie einer Einrichtung (44) zum wahlweisen Anlegen der Betriebs- oder der Referenzspannungsquelle an das Bauelement (12), dadurch gekennzeichnet, dass der Ausgang des Regelverstärkers (38) mit dem ersten Eingang eines Differenzverstärkers (46) und über einen Schalter (48) mit dem ersten Eingang eines Komparators (50) verbunden ist, an den jeweils zweiten Eingang des Differenzverstärkers (46) bzw. des Komparators (50) ein Soll-Wert ($U_S$) angelegt ist und der Ausgang des Komparators (50) mit dem Steuereingang der Spannungsversorgung (58) des Fotomultipliers (32) verbunden ist.

**Claims**

1. A process for the non-contact potential measurement at an electronic component, wherein the component (12) is inserted into an electron microscope (2) and a measuring point is supplied with primary electrons, wherein furthermore the secondary electron current emitted from the measuring point is fed to a retarding field spectrometer (20, 30) which possesses both a photo-multiplier (32) and a compensation circuit (40) having a regulating amplifier (38) for controlling the retarding field of the spectrometer (30) in dependence upon the voltage ($U_m$) at the measuring point (12), the regulating amplifier (32) being connected to the output of the photo-multiplier (32), and wherein furthermore prior to the performance of a measurement, the optimal operating point of the compensation circuit (40) is firstly adjusted in that the measuring point of the component (12) is connected to a predetermined potential and that the output voltage ($U_{R1}$) of the regulating amplifier (38) is then adjusted by means of the change of the photo-multiplier voltage ($U_{PM}$) while the measuring point of the component (12) is connected to the predetermined potential, and that the photomultiplier voltage ($U_{PM}$) is then maintained so as to be constant, and wherein the operating voltage is subsequently applied to the component (12), characterized in that in order to set the optimal operating point of the compensation circuit (40) the output voltage ($U_{R1}$) of the regulating amplifier (38) is compared with a predetermined theoretical value ($U_S$) while the measuring point of the component (12) is connected to the predetermined potential, that the photo-multiplier voltage ($U_{PM}$) is controlled in dependence upon the result of this comparison, and that during the measurement of the potential the photo-multiplier voltage ($U_{PM}$) is then maintained constant.

2. A process as claimed in Claim 1, characterized in that the measuring point of the component (12) is connected to zero potential as a predetermined potential.

3. An arrangement for the non-contact potential measurement at an electronic component with an electron microscope (2) for supplying a measuring point on the component (12) with primary electrons, and with a retarding field spectrometer (20, 30) which picks up the secondary electrons emitted from the measuring point and which possesses both a photo-multiplier (32) having a connected voltage supply unit (58) and a compensation circuit (40) which serves to control the retarding field of the spectrometer (20, 30) in dependence upon the potential at the measuring point, where the compensation circuit (40) includes a regulating amplifier (38) which is connected to the output of the photo-multiplier (32), and with an operating and reference voltage source and a device (44) for optionally connecting the operating or reference voltage source to the component (12), characterized in that the output of the regulating amplifier (38) is connected to the first input of a difference amplifier (46) and to the first input of a comparator (50) by means of a switch (48), and that a theoretical value ($U_S$) is connected to the second input of the difference amplifier (46) and the comparator (50) respectively, and the output of the comparator (50) is connected to the control input of the voltage supply unit (58) of the photo-multiplier (32).

**Revendications**

1. Procédé pour mesurer sans contact du potentiel sur un composant électronique, dans lequel le composant (12) est introduit dans un microscope électronique (2) et un point de mesure recevant des électrons primaires, dans lequel, ensuite, le courant d'électrons secondaires qui est émis par le point de mesure est appliqué à un spectromètre à champ antagoniste (20, 30) qui comporte un photomultiplicateur (32) ainsi qu'un circuit de compensation (40) à amplificateur de réglage (38) pour régler le champ antagoniste du spectromètre (30) en fonction de la tension au niveau du point de mesure (12), l'amplificateur de réglage étant relié à la sortie du photomultiplicateur (32), dans lequel, en outre, on règle d'abord le point de fonctionnement optimum du circuit de compensation (40) par l'exécution d'une mesure, en portant le point de mesure du composant (12) à un potentiel prédéterminé, et que l'on règle ensuite la tension de sortie ($U_{R1}$) de l'amplificateur de règlage (38) par l'intermédiaire de la tension ($U_{PM}$) du photomultiplicateur pendant que le point de mesure du composant (12) se trouve au potentiel prédéterminé et qu'ensuite la tension ($U_{PM}$) du photomultiplicateur est maintenue constante, et dans lequel on applique ensuite la tension de fonctionnement au composant (12), caractérisé par le fait que pour régler le point de fonctionnement optimum du circuit de compensation (40), la tension de sortie ($U_{R1}$) de l'amplificateur de réglage (38) est comparée, pendant que le point de mesure du composant (12) se trouve au potentiel prédéterminé, avec une valeur de consigne ($U_S$) prédéterminée, que la tension ($U_{PM}$) du photomultiplicateur est commandée en fonction du résultat de cette comparaison et qu'ensuite la tension ($U_{PM}$) du photomultiplicateur est maintenue constante pendant la mesure du potentiel.

2. Procédé selon la revendication 1, caractérisé par le fait que le point de mesure du composant (12) est porté au potentiel zéro, comme potentiel prédéterminé.

3. Dispositif pour mesurer sans contact le potentiel sur un composant électronique, avec un microscope électronique (2) pour charger un point de mesure du composant (12) avec des électrons primaires, avec un spectromètre à champ antagoniste (20, 30) saisissant les électrons secondaires émis par le point de mesure et comportant un photomultiplicateur (32) avec alimentation en tension (58) branchée, ainsi qu'un circuit de compensation (40) pour régler le champ antagoniste du spectromètre (20, 30) en fonction du potentiel du point de mesure, le circuit de compensation (40) comportant un amplificateur de réglage (38) relié à la sortie du photomultiplicateur, ainsi qu'avec un dispositif (44) pour relier au choix la source de tension de fonctionnement ou de référence au composant (12), caratérisé par le fait que la sortie de l'amplificateur de réglage (38) est reliée à la première entrée d'un amplificateur différentiel (46) et par l'instrémédiaire d'un interrupteur (48) à la première entrée d'un amplificateur différentiel (46) et par l'intermédiaire d'un interrupteur (48) à la première entrée d'un comparateur (50), qu'à la seconde entrée de l'amplificateur différentiel (46) ou du comparateur (50) est appliquée une valeur de consigne ($U_S$) et que la sortie du comparateur (50) est reliée à l'entrée de commande de l'alimentation en tension (58) du photomultiplicateur (32).